# EUROPÄISCHE PATENTSCHRIFT

(11) **EP 0 678 910 B1**
(45) Veröffentlichungstag und Bekanntmachung des Hinweises auf die Patenterteilung: **27.06.2001**
(21) Anmeldenummer: 95105931.0
(22) Anmeldetag: 20.04.1995
(51) Int. Cl.: H01L 21/66, G01R 31/311, G01N 21/88

(54) **Vorrichtung zur Kontrolle von Halbleiterscheiben**
Inspection system for semiconductor wafers
Système d'inspection de plaquettes semi-conductrices

(30) Priorität: 20.04.1994 DE 4413832
(43) Veröffentlichungstag der Anmeldung: 25.10.1995
(73) Patentinhaber: Infineon Technologies AG, 81669 München (DE)
(72) Erfinder: Biederman, Ernst, D-93053 Regensburg (DE); Ben el Mekki, Manfred, D-82256 Fürstenfeldbruck (DE); Weisheit, Kenneth, D-86154 Augsburg (DE); Griebsch, Thomas, D-81543 München (DE); Ross, Gerhard, D-80689 München (DE)
(74) Vertreter: Zedlitz, Peter, Dipl.-Inf.

(56) Entgegenhaltungen:
- EP-A- 0 319 797
- EP-A- 0 560 096
- US-A- 5 091 963
- US-A- 5 394 246
- MICROELECTRONICS JOURNAL, Bd. 24, Nr. 6, Oktober 1993 LUTON GB, Seiten 625-633, H. TSUKAHARA ET AL. 'Automated Visual Inspection System for Bonded IC Wires'

## Beschreibung

Die Erfindung betrifft eine Vorrichtung zur Kontrolle von Halbleiterscheiben.

Bei der Herstellung integrierter Halbleiterschaltungen sind die Halbleiterscheiben immer wieder auf einwandfreie Beschaffenheit zu kontrollieren. Dabei sollen fehlerhafte Halbleiterscheiben erkannt werden, so daß sie vom weiteren Fertigungsablauf entweder ganz ausgeschlossen werden können oder aber, daß sie vor dem weiteren Fertigungsablauf entsprechend nachbearbeitet werden können und dann, Fehlerfreiheit vorausgesetzt, wieder in den normalen Fertigungsablauf eingeschleust werden können.

Solche Kontrollen von Halbleiterscheiben auf einwandfreie Beschaffenheit (z. B. Kontrolle auf Partikelfreiheit, d. h. frei von Verschmutzungen und Ablagerungen, Kontrolle von aufgebrachten Lackschichten etc.) sind bekanntlich eminent wichtig für das Erzielen guter Ausbeuten im Fertigungsprozeß.

Diese Kontrollen werden zuweilen manuell durchgeführt mit Hilfe gewöhnlicher Mikroskope oder ohne Mikroskop bei schräg auffallendem Licht. Dies ist zum einen für das Personal sehr anstrengend, insbesondere für die Augen und den Rücken (Körperhaltung, stundenlanges Sitzen). Zum anderen ist es aber auch mit großen Unsicherheiten behaftet, weil beim Personal mit der Zeit die Konzentrationsfähigkeit nachläßt beim Erkennen von Fehlern und beim Sortieren nach guten und schlechten Scheiben.

In der US-A-5,394,246 wird eine Vorrichtung und ein Verfahren zur Kontrolle von Drahtverbindungen ("bonding wires") eines Halbleiterchips beschrieben. Die Vorrichtung weist eine ringförmige Beleuchtungseinrichtung auf zur Beleuchtung des zu untersuchenden Objekts unter einem geneigten Winkel. Über eine optische Einrichtung wird mit einer Kamera ein Kontrollbild des zu untersuchenden Teils des Objekts erstellt.

In dem Dokument Microelectronics Journal, Bd. 24, Nr. 6, Oktober 1993 Oxford GB, Seiten 625-633, "Automated Visual Inspection System for Bonded IC Wires" wird eine Vorrichtung zu einem ähnlichen Zweck beschrieben. Dort werden Kontrastbilder über zwei Beleuchtungsarten, Beleuchtung unter einem vertikalen und unter einem geneigten Winkel, erzeugt, die von einer Weitwinkelkamera aufgenommen werden. Aufgabe der vorliegenden Erfindung ist es eine weitere Vorrichtung zu schaffen, mit deren Hilfe der Vorgang des Kontrollierens automatisiert werden kann.

Diese Aufgabe wird bei der erfindungsgemäßen Vorrichtung gelöst durch die Merkmale des Patentanspruches 1.

Vorteilhafte Aus- und Weiterbildungen sind in Unteransprüchen gekennzeichnet.

Die Erfindung wird nachstehend anhand einer Zeichnung näher erläutert. Dabei zeigen:
- die Figur 1: eine Vorrichtung mit einer Beleuchtung unter einem flachen Einfallswinkel
- die Figuren 2 bis 3: Ausführungsformen der erfindungsgemäßen Vorrichtung,
- die Figuren 4 bis 8: Einzelheiten in Verbindung mit der Beschreibung eines möglichen Verfahrens.

Nachstehend wird eine Vorrichtung zur Kontrolle von Halbleiterscheiben mit einer Beleuchtung unter einem flachen Einfallswinkel erläutert.

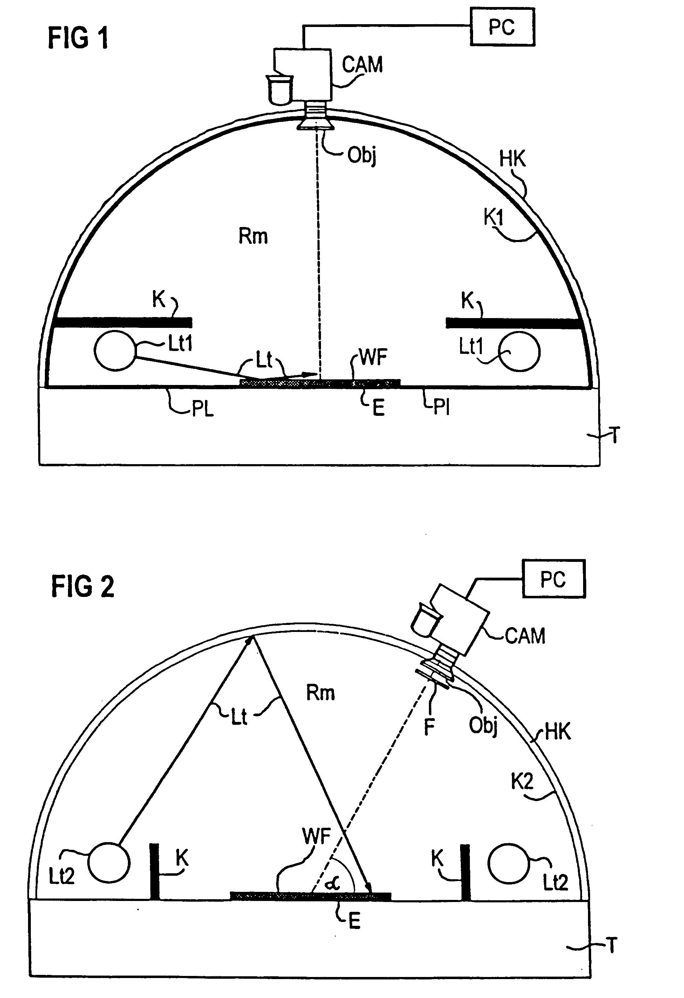

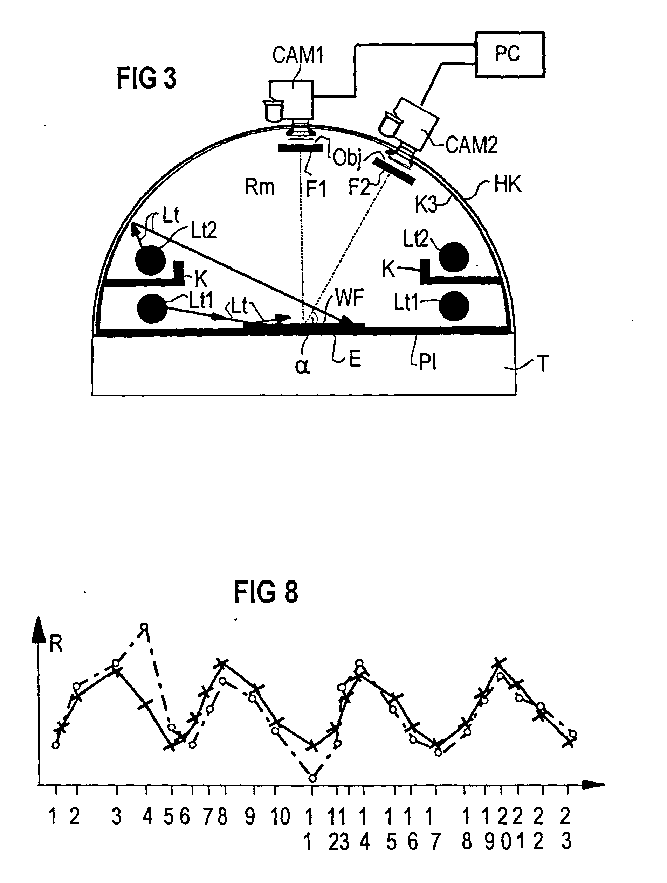

Figur 1 zeigt eine Vorrichtung, die beispielsweise auf einem Tisch T (gilt auch für die weiteren beiden Ausführungsformen nach den Figuren 2 und 3) oder einer sonstigen geeigneten Unterlage mit festem Stand angeordnet sein kann. Die Vorrichtung weist eine Einrichtung E auf zur Aufnahme der zu kontrollierenden Halbleiterscheibe WF sowie eine Bodenplatte Pl, die jedoch nicht zwingend notwendig ist. Die Einrichtung E kann Bestandteil der Bodenplatte Pl sein. Sie kann aber auch, gemäß weiteren Ausgestaltungen der erfindungsgemäßen Vorrichtung, auf der Bodenplatte Pl angeordnet oder in diese eingelassen sein. Die Vorrichtung weist weiterhin eine halbkugelförmige Abdeckeinrichtung HK auf mit einem Innenraum Rm, der mittels der Bodenplatte Pl weitgehend abgeschlossenen ist.

Innerhalb dieses abgeschlossenen Raumes Rm ist eine vorzugsweise, jedoch nicht unbedingt notwendigerweise ringförmige Beleuchtungseinrichtung Ltl angeordnet, die einer direkten Beleuchtung der zu kontrollierenden Halbleiterscheibe WF dient. Die ringförmige Ausgestaltung ermöglicht eine gleichmäßige Beleuchtung der Halbleiterscheibe WF. Die halbkugelförmige Abdeckeinrichtung HK weist innerhalb des abgeschlossenen Raumes Rm eine Oberfläche K1 auf, welche auftreffendes Licht Lt absorbiert.

Oberhalb der Beleuchtungseinrichtung Lt1 ist eine weitere Abdeckeinrichtung K angeordnet, welche auftreffendes Licht Lt absorbiert. Sie ist so ausgebildet, daß die Halbleiterscheibe WF direkt beleuchtbar ist mittels der Beleuchtungseinrichtung Lt1, während die halbkugelförmige Abdeckung HK größtenteils gegenüber dem direkten Licht der Beleuchtungseinrichtung Lt1 abgedeckt ist. Infolge dieser Anforderungen ist es insbesondere bei ringförmiger Auslegung der Beleuchtungseinrichtung Lt1 günstig, auch die weitere Abdeckeinrichtung K ringförmig auszulegen.

Senkrecht oberhalb des Mittelpunktes der Einrichtung E zur Aufnahme der zu kontrollierenden Scheibe WF ist an der halbkugelförmigen Abdeckeinrichtung HK eine Kamera CAM so angeordnet, daß ihr Objektiv Obj in den abgeschlossenen Raum Rm blickt, insbesondere auf die Stelle, an der sich im Betrieb die zu kontrollierende Halbleiterscheibe WF befindet. Die Kamera CAM kann dabei so angeordnet sein, daß ihr Objektiv Obj in den abgeschlossenen Raum Rm hineinragt, wie in Figur 1 dargestellt, oder aber auch so, daß der Rand ihres Objektives Obj in etwa bündig mit der halbkugelförmigen Abdeckung HK abschließt.

Die Kamera CAM ist mit einer Auswerteeinrichtung PC verbunden, die der Steuerung der Kamera dient sowie zum Empfang, zur Zwischenspeicherung, zur Verarbeitung und zur Ausgabe von von der Kamera CAM übermittelten Daten. Diese Daten können analog (in Form von "Bildern") oder digital übermittelt werden, sofern die Kamera CAM bereits für Digitalübermittlung ausgerüstet ist (z. B., wenn sie A/D-Wandler aufweist). Die Auswerteeinrichtung PC ist dabei typischerweise eine Rechnereinrichtung wie ein Personal Computer oder eine Datenverarbeitungsanlage. Es ist aber auch vorstellbar, daß sie ausschließlich aus einer ein entsprechendes Verfahren ausführenden Hardware gebildet ist.

Folgende Ausgestaltungen der Vorrichtung sind vorteilhaft:

Die das Licht Lt absorbierende Oberfläche K1 der halbkugelförmigen Abdeckung HK ist schwarz.

Das von der Beleuchtungseinrichtung Lt1 ausgesandte Licht Lt ist weiß.

Die weitere Abdeckeinrichtung K hat eine schwarze Oberfläche.

Die Oberfläche der Bodenplatte Pl ist auf ihrer der halbkugelförmigen Abdeckeinrichtung HK zugewandten Seite schwarz.

Soweit sich innerhalb des abgeschlossenen Raumes Rm weitere Teile der Kamera CAM befinden, so sind die diese so angeordnet, daß sie, von der zu kontrollierenden Halbleiterscheibe WF her betrachtet, durch das Objektiv Obj verdeckt sind.

Mittels dieser Vorrichtung ist der Vorgang des Kontrollierens automatisierbar beispielsweise mit Hilfe des nachstehend beschriebenen Verfahrens.

Da Halbleiterscheiben WF häufig ein sogenanntes Flat Ft (siehe Figur 5) aufweisen (d. h., ein Bereich der an sich runden Halbleiterscheibe WF ist abgeflacht), wird bei dem nachstehenden Verfahren davon ausgegangen, daß die zu kontrollierenden Halbleiterscheiben WF ein solches Flat Ft aufweisen. Weiterhin ist zugrunde gelegt, daß die im Herstellungsprozeß auf den Halbleiterscheiben WF zu bildenden Halbleiterchips rechteckig, ggf. quadratisch sind und daß sie parallel zum Flat Ft ausgerichtet sind.

Weiterhin ist noch angenommen, daß die mittels der zu kontrollierenden Halbleiterscheibe WF zu fertigenden Halbleiterchips integrierte Halbleiterspeicher sind, die bekanntlich unabhängig von ihrer Speicherart {z. B. flüchtige Speicher wie DRAM's, SRAM's, nicht-flüchtige Speicher (NV-Memories) wie ROM's, PROM's, EEPROM's}, große Bereiche SQ (siehe Figur 5) regelmäßiger Strukturen aufweisen (die sogenannten Speicherzellenblöcke oder Speicherzellenfelder) sowie Bereiche unregelmäßiger Strukturen, welche z. B. die sogenannten peripheren Schaltungen, wie z. B. Decoder und Verstärker und die Anschlußflächen (pads) enthalten. Die Bereiche regelmäßiger Strukturen SQ umfassen in der Regel ca. 80 bis 95% des gesamten Speicherchips. Außerdem sind auf einer solchen Halbleiterscheibe WF noch Bereiche zwischen den einzelnen Chips angeordnet, welche einem Zerteilen der (fertigen) Halbleiterscheibe WF zur Montage der einzelnen Chips in ein Gehäuse, in eine Chipkarte oder ähnlichem dienen (allgemein mit Ritz-Rahmen bezeichnet). Bei dem Verfahren werden lediglich die Bereiche regelmäßiger Strukturen SQ kontrolliert, was in Anbetracht ihres großen Anteils an der Gesamtfläche der Halbleiterscheibe WF völlig ausreichend ist.

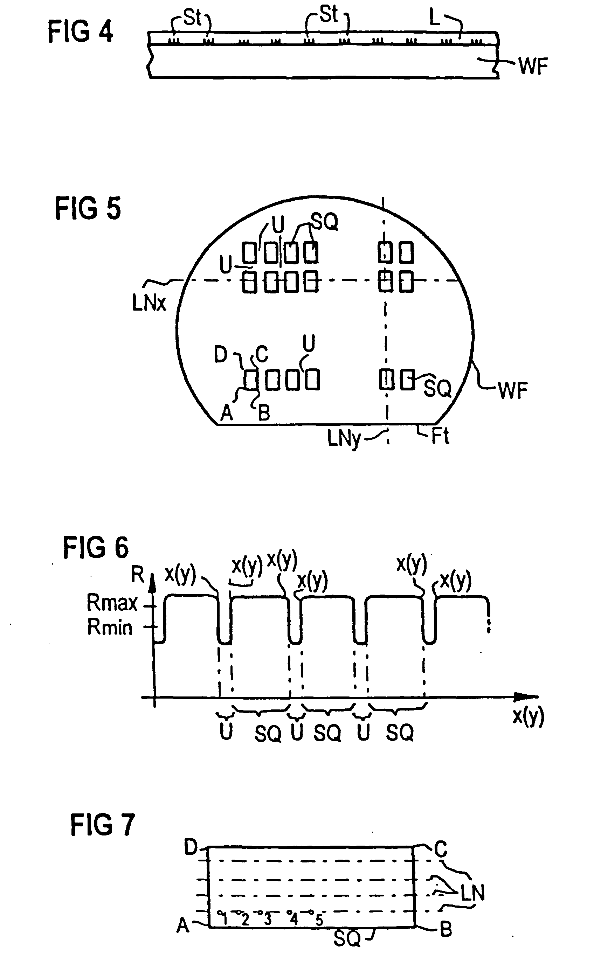

Darüber hinaus ist noch Voraussetzung für das Verfahren, daß die Halbleiterscheibe WF (dargestellt in Figur 4) wenigstens eine Schicht aufweist, die bereits Strukturen St der zu fertigenden Halbleiterchips enthält, sowie als oberste Schicht eine Lackschicht L (für weitere Strukturierungsschritte), die zu kontrollieren sind (dargestellt in Fig. 4).

Eine Automatisierung mittels der Vorrichtung bietet folgende Vorteile:
- Bei gleicher oder gar kürzerer Meßzeit (pro Scheibe) können mehr Meßpunkte kontrolliert werden, d. h. die Kontrolle ist genauer,
- Menschliche Fehlentscheidungen (Verwechseln der Erkennung von Gut/Ausfall und der Sortierung nach Gut/Ausfall) sind ausgeschlossen,
- Bei kürzerer Meßzeit pro Scheibe erhöht sich der Durchsatz, d. h. die Produktivität je Mitarbeiter.

Darüber hinaus eröffnet sich auch die Möglichkeit, daß ein Mitarbeiter mehrere Vorrichtungen, welche automatisch Halbleiterscheiben WF kontrollieren, bedient, so daß die Produktivität nochmals erhöht werden kann (höhere Produktivität bedeutet bekanntlich niedrigere Herstellungskosten, was heutzutage eminent wichtig ist für die Hersteller integrierter Schaltungen).

Das Verfahren läuft folgendermaßen ab:

Die Halbleiterscheibe WF wird direkt beleuchtet durch die Beleuchtungseinrichtung Lt1, z. B. mit weißem Licht. Die auf die Halbleiterscheibe WF aufgebrachte Lackschicht L reflektiert das Licht Lt.

Mittels der senkrecht über der Halbleiterscheibe WF angeordneten Kamera CAM, welche aufgrund ihrer Anordnung auf die Halbleiterscheibe "blickt", wird nun der Reflexionsgrad R des reflektierten Lichtes Lt nach folgendem Vorgehen ermittelt (unter Reflexionsgrad R wird hierbei das Maß der Helligkeit verstanden, die von der Halbleiterscheibe WF her auf das Objektiv der Kamera CAM trifft bzw. wirkt) :

Zunächst wird mittels der Auswerteeinrichtung PC eine erste Linie LNx, die als Meßlinie dient und die in gegebenem Abstand parallel zum Flat Ft verläuft, auf der Oberfläche des Lackes L der Halbleiterscheibe WF simuliert, d. h. "gedacht". Die Helligkeit der Halbleiterscheibe WF, d. h., der Wert des Reflexionsgrades R, wird entlang dieser gedachten Linie LNx an ausgewählten Punkten Px ("Pixel", nicht dargestellt aus Gründen der Übersichtlichkeit) durch Kamera CAM und Auswerteeinrichtung PC ermittelt und zusammen mit dem Lagewert x dieser Punkte Px in der Auswerteeinrichtung PC zwischengespeichert.

Ergeben sich längs dieser gedachten Linie LNx mehrheitlich Werte des ermittelten und gemessenen Reflexionsgrades R, welche unterhalb eines vorgegebenen Mindestwertes Rmin liegen, so werden die ermittelten und zwischengespeicherten Daten bezüglich dieser Linie LNx als unbrauchbar verworfen. Es wird nämlich angenommen, daß die Linie LNx überwiegend nicht durch die großen Flächen SQ der regelmäßigen Strukturen verläuft, sondern durch die Bereiche unregelmäßiger Strukturen oder durch einen Ritz-Rahmen. Diese Bereiche und der Ritz-Rahmen ("U" genannt; vergleiche Figur 5) sollen jedoch vereinbarungsgemäß nicht kontrolliert werden. Statt der bislang vermessenen gedachten Linie LNx wird nun, in gegebenem Abstand zu dieser gedachten Linie LNx, eine weitere "gedachte" Linie LNx1 ausgewählt und verwendet (in Figur 5 aus Gründen der Übersichtlichkeit nicht dargestellt), bezüglich deren der Reflexionsgrad R genauso ermittelt und zwischengespeichert wird samt den zugehörigen Lagewerten x wie bezüglich der ursprünglich verwendeten gedachten Linie LNx.

Sollten die Werte des Reflexionsgrades R dieser weiteren gedachten Linie LNx1 auch mehrheitlich Werte aufweisen unterhalb des Mindestwertes Rmin, so wird der gesamte Vorgang "Verwerfen der Daten dieser Linie LNx1, Annahme einer weiteren gedachten Linie LNx2, Ermitteln und Auswerten der Werte ihres Reflexionsgrades R und der zugehörigen Lagewerte x, sowie Zwischenspeichern" nochmals durchgeführt entsprechend dem oben beschriebenen.

Dies erfolgt insgesamt so oft, bis eine gedachte Linie LNx, LNx1, LNx2... gefunden wurde, deren Werte des Reflexionsgrades R mehrheitlich dem Kriterium des Mindestwertes Rmin genügen. Falls eine solche gedachte Linie LNx, LNx1,... nicht ermittelt werden kann (ggf. beschränkt auf eine Höchstzahl an Versuchen, eine geeignete Linie LNx zu finden), die dieses Kriterium erfüllt, so wird die Kontrolle dieser Halbleiterscheibe WF abgebrochen, weil angenommen wird, daß entweder ein Fehler größeren Ausmaßes vorliegt oder aber die Halbleiterscheibe WF vielleicht noch gar keine Strukturen St aufweist unterhalb der Lackschicht L.

In dem Fall, in dem die Suche nach einer gedachten Linie LNx,..., die parallel zum Flat Ft liegt, zu Werten des Reflexionsgrades R geführt haben, die mehrheitlich dem Kriterium des minimalen Reflexionsgrades Rmin genügen, wird nun, ganz entsprechend dem bisherigen, irgendwo über die zu kontrollierende Halbleiterscheibe WF senkrecht zur gefundenen gedachten Linie (künftig sei angenommen, daß dies die erste gedachte Linie LNx war) eine neue gedachte Linie LNy simuliert. Entlang deren werden an Meßpunkten Py wiederum die Werte des Reflexionsgrades R des reflektierten Lichtes Lt (samt deren zughörigen Lagewerten y) mittels der Kamera CAM und der Auswerteeinrichtung PC gemessen und zwischengespeichert. Auch diese Werte müssen mehrheitlich dem Kriterium des minimalen Reflexionsgrades Rmin genügen (wobei aber vorstellbar ist, daß dieser ggf. einen anderen Wert aufweisen kann bezüglich der gedachten Linie LNx parallel zum Flat Ft). Falls sie nicht genügen, werden bezüglich der neuen gedachten Linie LNy die bezüglich der gedachten Linie LNx bereits beschriebenen Schritte zum Finden einer gedachten Linie LNx1, LNx2,... analog ausgeführt mit weiteren neuen gedachten Linien LNy1, LNy2 usw. (jeweils in einem gegebenen Abstand zur vorher vermessenen neuen gedachten Linie LNy, LNy1 etc.) so lange, bis entweder erkannt ist (ggf. nach einer vorgegebenen maximalen Zahl von Versuchen), daß keine neue gedachte Linie LNy,... gefunden werden kann, die dem Kriterium des minimalen Reflexionsgrades Rmin genügt (dann erfolgt Abbruch der Kontrolle der betroffenen Halbleiterscheibe WF) oder aber bis eine solche Linie gefunden ist (angenommenermaßen sei dies für die weitere Beschreibung die ursprüngliche Linie LNy).

In dem Fall, in dem verwendbare gedachte Linien LNx und LNy gefunden werden konnten, sind also die Lagewerte x (für die gedachte Linie LNx) und y (für die gedachte Linie LNy) der jeweiligen Meßpunkte dieser Linien LNx und LNy bereits zwischengespeichert. Die Lagewerte sind bezogen auf die Lage des Flats Ft. Die Meßpunkte Px und Py sollten nach Möglichkeit in so engem Abstand zueinander gelegt worden sein, daß damit möglichst genau (d. h., über deren zugehörigen Werte des Reflexionsgrades R) die Grenzen zwischen den jeweiligen Flächen SQ regelmäßiger Strukturen zu den Bereichen U (unregelmäßige Strukturen und Ritz-Rahmen) erfaßt sind.

Figur 6 zeigt beispielhaft den Verlauf der gemessenen Werte des Reflexionsgrades R entlang der gedachten Linie LNx. Gleiches gilt entsprechend der gedachten Linie LNy, was durch die in Klammern besetzte Bezeichnung "y" auf der Abszisse angedeutet ist. Dabei steht "SQ" für die (angenommenermaßen rechteckigen) großen Flächen SQ regelmäßiger Strukturen während "U" für die (kleineren) Bereiche unregelmäßiger Strukturen sowie der jeweiligen Ritz-Rahmen steht. Die weiteren verwendeten Bezeichnungen "X" und "Y" (in Klammern stehend) werden nachstehend noch erläutert. Dem Bild zugrunde liegt die Tatsache, daß die großen Flächen SQ regelmäßiger Strukturen im Normalfall hohe Werte des Reflexionsgrades R aufweisen, während die Bereiche U einen meist deutlich niedrigeren Wert des Reflexionsgrades R aufweisen.

Für die weiteren Verfahrensschritte, d. h. für eine Halbleiterscheibe WF, für die gedachte Linien LNx, LNy gefunden worden waren, die dem Kriterium des Minimalwertes Rmin genügten, sind nun diejenigen Punkte, d. h. die Koordinaten X, Y (siehe Figur 6) interessant, die am Rand der großen Flächen SQ regelmäßiger Strukturen zu den restlichen Bereichen U unregelmäßiger Strukturen und der Ritz-Rahmen liegen (d. h. die Eckpunkte A, B, C, D der großen Flächen SQ, wie in den Figuren 5 und 7 gezeigt), da die Bereiche U vereinbarungsgemäß von der Kontrolle ausgeschlossen sein sollen. Zu diesem Zweck werden aus den Lagepunkten x der einen gedachten Linie LNx (bzw. der als Ersatz dafür vewendeten weiteren gedachten Linie LNx1 bzw. LNx2 bzw. ...) und den Lagepunkten y der anderen gedachten Linie LNy (bzw. der als Ersatz dafür verwendeten weiteren gedachten Linie LNy1 bzw. LNy2 bzw. ...), deren zugehöriger Werte des Reflexionsgrades R sowie der Information, daß die Flächen SQ (d. h. die Speicherzellenfelder) rechteckig sind, diese Koordinaten X, Y mittels der Auswerteeinrichtung PC ermittelt.

Die Ermittlung erfolgt in mathematisch leicht durchführbarer Art aus der Information, daß die großen Flächen SQ Rechtecke bilden, die sich in x- und y-Richtung (d. h. parallel und senkrecht zum Flat Ft und somit parallel bzw. senkrecht zu den gedachten Linien LNx, LNy) regelmäßig wiederholen und aus dem Beurteilungskriterium, daß nur solche Lagepunkte x bzw. y der beiden gedachten Linien LNx, LNy berücksichtigt werden, deren zugehöriger Wert des Reflexionsgrades R einen vorgegebenen Maximalwert Rmax zwar überschreiten, die jedoch gleichzeitig Nachbarpunkte von solchen Lagewerten x bzw. y sind, die diesen Maximalwert Rmax unterschreiten. Alle Lagepunkte x bzw. y, deren zugehöriger Wert des Reflexionsgrades R unterhalb dieses Maximalwertes Rmax liegen, werden vom weiteren Verfahren ausgeblendet als Bereiche U, die nicht zu kontrollieren sind.

Damit sind bezüglich der zu kontrollierenden Halbleiterscheibe WF sämtliche rechteckigen Flächen SQ (die ggf. auch quadratisch sein könnten als Spezialfall eines Rechteckes) definiert, innerhalb deren die Kontrolle erfolgen soll. Die Bereiche U seien vereinbarungsgemäß von der Kontrolle ausgeschlossen. Weiterhin sind von der Kontrolle auch unvollständige Flächen SQ, die den sogenannten unvollständigen Randchips einer Halbleiterscheibe WF entsprechen, ausschließbar.

Die weiteren Verfahrensschritte, die nachstehend bezüglich einer Fläche SQ beschrieben werden, werden sukzessive auf jede einzelne rechteckige Fläche SQ der Halbleiterscheibe WF angewandt. Sie basieren ebenfalls auf dem Prinzip gedachter Linien, die jedoch im Unterschied zu den vorstehend genannten gedachten Linien LNx, LNy nunmehr als Meßlinien LN bezeichnet werden.

Bei jeder der zu kontrollierenden rechteckigen Flächen SQ (siehe Figur 7) wird wenigstens eine Meßlinie LN "gedanklich" parallel zu einer Kante (in Figur 7 beispielhaft dargestellt anhand von vier Meßlinien LN: parallel zur Kante AB bzw. CD) "gelegt", z. B. parallel zur längeren Kante.

Entlang jeder dieser Meßlinien LN wird mittels der Kamera CAM und der Auswerteeinrichtung PC an vorgegebenen Meßpunkten 1, 2, 3,... der jeweilige Wert des Reflexionsgrades R ermittelt und zwischengespeichert. Je mehr Meßlinien LN je Fläche SQ verwendet werden und je mehr solche Punkte 1, 2, 3,... vorgegeben sind, desto genauer ist die Kontrolle.

Für den Reflexionsgrad R entlang zweier ausgewählter Meßlinien LN ergeben sich beispielsweise die in Figur 8 dargestellten beiden Verläufe. Auf der Abszisse sind die Meßpunkte 1 bis 23 aufgetragen. Auf der Ordinate ist der jeweilige Wert des Reflexionsgrades R ablesbar.

Die mit "x" eingetragenen Werte des Reflexionsgrades R sind Werte entlang einer ersten Meßlinie LN. Wie die nachstehend noch aufgeführten möglichen Kriterien zur Erkennung, ob ein Fehler vorliegt oder nicht, zeigen, ist entlang dieser Meßlinie kein Fehler erkennbar. Es liegen zwar verschiedene Werte des Reflexionsgrades R vor (verursacht durch die verschiedenen Strukturen innerhalb der Fläche SQ, unterhalb der Lackschicht L). Diese sind jedoch, wie anhand der nachstehend genannten Beurteilungskriterien erkennbar ist, im Bereich der üblichen, zu erwartenden Werte, so daß die kontrollierte Fläche SQ bezüglich dieser Meßlinie LN als "gut" zu bewerten ist. Die Werte des Reflexionsgrades R weisen einen periodischen Verlauf auf. Dies rührt davon, daß heutzutage integrierte Halbleiterspeicher (ein solcher ist ja mit der vorliegenden Halbleiterscheibe WF, und somit mittels der betrachteten Flächen SQ zu fertigen) mehrere nebeneinander angeordnete Speicherzellenfelder aufweisen. Jede dargestellte Periode entspricht also einem solchen (künftigen) Speicherzellenfeld.

Die in Figur 8 mit "o" eingetragenen Werte des Reflexionsgrades R sind Meßwerte entlang einer zweiten Meßlinie LN beispielsweise derselben Fläche SQ. Auffallend dabei sind die Meßpunkte 4 und 11.

Der Wert des Reflexionsgrades R beim Meßpunkt 4 (d. h. innerhalb der ersten Periode) liegt deutlich oberhalb der sonstigen Meßpunkte, insbesondere auch bezüglich derer lokaler Maximalwerte innerhalb einer jeden der weiteren Perioden 2.... Hier liegt ein Fehler vor, der durch einen weißen Partikel verursacht ist. Weil ein weißer Partikel das Licht Lt besser abstrahlt als die sonstigen Stellen der Lackschicht L, ist dieser Wert besonders hoch.

Der Wert des Reflexionsgrades R bei Meßpunkt 11, der sich (zufälligerweise) am Übergang von der zweiten zur dritten Periode befindet, ist besonders niedrig, verglichen mit den restlichen Meßpunkten, insbesondere mit den minimalen Werten in den einzelnen Perioden. Dies läßt darauf schließen, daß an der betreffenden Stelle der Fläche SQ, die sich zwischen dem zweiten und dritten (noch herzustellenden) Speicherzellenfeld befindet, ein dunkler Partikel vorhanden ist. Es könnte jedoch auch sein, daß an dieser Stelle die Lackschicht L zu dünn ist oder gar ein Loch aufweist. Damit könnten bei der weiteren Herstellung des Speicherchips an dieser Stelle Strukturierungsfehler wie Unterätzen etc. auftreten. Auf jeden Fall zeigen die Meßwerte entlang der zweiten Meßlinie LN zwei Fehler auf, von denen jeder einzelne bei Erkennen zu einem entsprechenden Aussortieren der Halbleiterscheibe WF führt und ggf. zu Nacharbeiten.

Mit Hilfe der Meßpunkte 1, 2,... je Meßlinie LN wird also anhand von Beurteilungskriterien durch die Auswerteeinrichtung PC ermittelt, ob die untersuchte rechteckige Fläche SQ, und damit die gesamte Halbleiterscheibe WF, in Ordnung ist oder fehlerhaft. Die Ergebnisse (ggf. samt den geometrischen Daten, wo sich Fehler befinden) sind dann mittels der Auswerteeinrichtung PC ausgebbar z. B. in Form von Daten auf Speichermedien (Magnetbänder, Festplatte), durch Ausdrucken oder durch Ansteuern entsprechender Maschinen zur Nachbearbeitung. Es sind hier vielerlei Möglichkeiten vorstellbar.

Insbesondere folgende Beurteilungskriterien sind einsetzbar bei der Beurteilung, ob die kontrollierte Halbleiterscheibe WF bzw. deren rechteckige Flächen SQ in Ordnung sind oder nicht:

Es können, entweder für jede Meßlinie LN einer Fläche SQ getrennt, oder aber für alle Meßlinien LN der betreffenden Fläche SQ, die Maximalwerte des Reflexionsgrades R der einzelnen auftretenden Perioden ermittelt werden und daraufhin überprüft werden, ob sie sich um mehr als einen vorgegebenen, zulässigen Differenzwert voneinander unterscheiden. Ist dies der Fall, so wird ein Fehler angenommen; der betreffende Wert und die zugehörigen Koordinaten werden zwischengespeichert und ggf. ausgegeben oder weiterverarbeitet.

Dasselbe kann bezüglich der entsprechenden Minimalwerte des Reflexionsgrades R durchgeführt werden.

Wenn alle rechteckigen Flächen SQ der Halbleiterscheiben WF mittels des geschilderten Verfahrens kontrolliert sind, und entsprechende Aussagen über die kontrollierte Scheibe WF getroffen wurden, so ist dieses Verfahren beendet.

Figur 2 zeigt eine Ausführungsform der erfindungsgemäßen Vorrichtung. Sie ist ähnlich aufgebaut wie die als erstes beschriebene Vorrichtung, unterscheidet sich allerdings in einigen Punkten deutlich von dieser.

Die Ausführungsform weist ebenfalls eine Einrichtung E auf zur Aufnahme der zu kontrollierenden Halbleiterscheibe WF sowie eine Beleuchtungseinrichtung Lt2. Diese dient jedoch einer indirekten Beleuchtung der Halbleiterscheibe WF. Außerdem ist auch die bereits vorgestellte halbkugelförmige Abdeckeinrichtung HK vorhanden, allerdings mit einer Oberfläche K2 in ihrem Inneren, welche auftreffendes Licht Lt in hohem Maße reflektiert. Sie ist deshalb vorzugsweise weiß. Im Inneren der Halbkugel sind aus Sicht der halbkugelförmigen Abdeckeinrichtung HK die Beleuchtungseinrichtung Lt2 und die Einrichtung E an der an den Innenraum Rm und an die halbkugelförmige Abdeckeinrichtung HK angrenzenden Bodenfläche angeordnet. Weiterhin ist zwischen der Beleuchtungseinrichtung Lt2 und der Einrichtung E zur Aufnahme der zu kontrollierenden Halbleiterscheibe WF eine weitere, auftreffendes Licht Lt absorbierende Abdeckeinrichtung K angeordent, die so ausgebildet ist, daß sie direkten Lichteinfall auf die Einrichtung E samt der Halbleiterscheibe WF verhindert, d.h., die Halbleiterscheibe WF ist lediglich indirekt beleuchtbar mit der Beleuchtungseinrichtung Lt2 durch Reflexion des Lichtes Lt an der halbkugelförmigen Abdeckeinrichtung HK. An der halbkugelförmigen Abdeckung HK ist auch eine Kamera CAM so angeordnet, daß ihr Objektiv Obj in den Raum Rm innerhalb der halbkugelförmigen Abdeckeinrichtung HK blickt. Bezüglich des Mittelpunktes der Einrichtung E zur Aufnahme der Halbleiterscheibe WF ist die Kamera CAM jedoch nicht senkrecht angeordnet wie bei der ersten Ausführungsform nach Figur 1, sondern in einem Winkel α, der größer als 0° ist und kleiner als 90°. Als gut hat sich eine Winkelstellung von 40° bis 70° erwiesen bei einem optimalen Wert von 60°. In diesem Fall kann sich nämlich die Kamera weder direkt noch indirekt auf der Halbleiterscheibe WF spiegeln, was ein Erfassen der Werte des Reflexionsgrades R stören würde. Weiterhin ist es günstig, wenn das Objektiv Obj der Kamera CAM mit einem Rotfilter F ausgerüstet ist, welches den Kontrast des empfangenen Bildes steigert.

Die Kamera CAM ist, wie auch bei der als erstes beschriebenen Vorrichtung, mit einer Auswerteeinrichtung PC verbunden, die der Steuerung der Kamera CAM dient sowie zum Empfang, zur Verarbeitung, zur Zwischenspeicherung und zur Ausgabe der von der Kamera CAM übermittelten Daten bzw. Bilder.

Folgende weitere Ausgestaltungen sind bei den Vorrichtungen nach den Figuren 1 und 2 vorteilhaft:

Das Licht der Beleuchtungseinrichtungen Lt1 bzw. Lt2 ist weiß. Die weiteren Abdeckeinrichtungen K weisen eine schwarze Oberfläche auf. Innerhalb der halbkugelförmigen Abdeckeinrichtung HK befindliche weitere Teile der Kamera CAM sind, soweit überhaupt vorhanden, so angeordnet, daß diese, von der Halbleiterscheibe WF bzw. der Einrichtung E her betrachtet, durch das Objektiv Obj verdeckt sind. Weiterhin ist es vorteilhaft im Sinne einer gleichmäßigen Ausleuchtung, wenn die Beleuchtungseinrichtungen Lt1 bzw. Lt2 und/oder die weiteren Abdeckungen K ringförmig sind. Eine Bodenplatte Pl ist nicht unbedingt notwendig (außerhalb vielleicht aus mechanischen Gründen, aus Stabilitätsgründen oder aus Gründen einer einfacheren Verarbeitung aufgenommener Bilder). Soweit sie jedoch vorhanden ist, sollte sie lichtabsorbierend, am besten schwarz sein.

Die zweite Auführungsform hat folgenden Vorteil gegenüber der als erstes beschriebenen Vorrichtung: Es gibt Defekte bei Halbleiterscheiben WF, die bei senkrecht stehender Kamera CAM und/oder bei direkter Bestrahlung der Halbleiterscheibe WF nicht sichtbar gemacht werden können und damit nicht erkennbar sind. Mit der Ausführungsform der erfindungsgemäßen Vorrichtung, d. h. mittels indirekter Beleuchtung und mittels schräg gestellter Kamera CAM lassen sich jedoch auch diese Defekte in den meisten Fällen erkennen, so daß rechtzeitige Nacharbeiten der betreffenden Halbleiterscheiben WF möglich sind, was wiederum die Ausbeute an den zu fertigenden Halbleiterspeichern steigert und damit die Produktionskosten insgesamt senkt.

Eine weitere Ausführungsform der Vorrichtung, dargestellt in Figur 3, vereint die Vorteile der ersten beiden Vorrichtungen, nämlich Erkennen von Defekten sowohl mit senkrecht stehender Kamera CAM1 und direkter Beleuchtung als auch mit schräg stehender Kamera CAM2 und indirekter Beleuchtung. Die Ausführungsform wird anhand von Figur 3 nachstehend beschrieben.

Sie weist wiederum eine Einrichtung E auf zur Aufnahme der zu kontrollierenden Halbleiterscheibe WF. Sie hat zwei Beleuchtungseinrichtungen Lt1, Lt2, wovon die erste (Ltl) einer direkten Beleuchtung der Halbleiterscheibe WF mit einer ersten Farbe Gn dient, die vorzugsweise grün ist und wovon die zweite Beleuchtungseinrichtung Lt2 einer indirekten Beleuchtung der Halbleiterscheibe WF dient mit einer zweiten Farbe Rt, die zur ersten Farbe Gn komplementär ist. Die zweite Farbe Rt ist vorzugsweise rot. Eine halbkugelförmige Abdeckeinrichtung HK, die ebenfalls Bestandteil dieser dritten Vorrichtung ist, hat in ihrem Innenraum Rm eine Oberfläche K3, die ebenfalls von der zweiten Farbe Rt ist, also vorzugsweise rot. Die halbkugelförmige Abdeckung HK bildet mittels einer Bodenplatte Pl, die aber nicht zwingend notwendig ist, einen weitgehend geschlossenen Innenraum Rm. Innerhalb des Innenraums Rm sind an der an den Innenraum Rm und an die halbkugelförmige Abedeckeinrichtung Hk angrenzenden Bodenfläche angeordnet: aus Sicht der halbkugelförmigen Abdeckeinrichtung HK die erste Beleuchtungseinrichtung Lt1 zur direkten Beleuchtung der Halbleiterscheibe WF, d. h., wie in Figur 3 erkennbar, zur Beleuchtung der Halbleiterscheibe WF mit nicht an der halbkugelförmigen Abdeckeinrichtung Hk reflektiertem Licht Lt1, und die Einrichtung E. Oberhalb der ersten Beleuchtungseinrichtung Lt1 ist die zweite Beleuchtungseinrichtung Lt2 angebracht. Die Bodenplatte Pl kann auf ihrer dem Raum Rm zugewandten Oberfläche die zweite Farbe Rt aufweisen, also vorzugsweise rot. Die Oberfläche könnte in einer anderen Ausgestaltung jedoch auch schwarz sein. Oberhalb der ersten Beleuchtungseinrichtung Lt1 ist eine weitere Abdeckeinrichtung K angeordnet, die lichtundurchlässig ist. Sie ist so ausgebildet, daß einerseits die Halbleiterscheibe WF mittels der ersten Beleuchtungseinrichtung Lt1 direkt beleuchtbar ist und daß andererseits diese Halbleiterscheibe WF durch die zweite Beleuchtungseinrichtung Lt2 lediglich indirekt beleuchtbar ist.

Senkrecht oberhalb des Mittelpunktes der Einrichtung E zur Aufnahme der Halbleiterscheibe WF ist an der halbkugelförmigen Abdeckeinrichtung HK eine erste Kamera CAM1 so angeordnet, so daß ihr Objektiv Obj in den Raum Rm innerhalb der halbkugelförmigen Abdeckeinrichtung HK und dort auf die Einrichtung E blickt. Die erste Kamera CAM1 weist ein Filter F1 auf, welches nur Licht der ersten Farbe Gn, also vorzugsweise grünes Licht passieren läßt (= Grünfilter).

Des weiteren ist an der halbkugelförmigen Abdeckeinrichtung HK eine Kamera CAM2 so angeordnet, daß ihr Objektiv Obj in den Raum Rm innerhalb der halbkugelförmigen Abdeckeinrichtung HK und dort auf die Einrichtung E blickt. Auch die zweite Kamera CAM2 weist ein Filter F2 auf, welches allerdings nur Licht der zweiten Farbe Rt, also vorzugsweise rotes Licht passieren läßt (= Rotfilter).

Die zweite Kamera CAM2 ist bezüglich des Mittelpunktes der Einrichtung E in einem Winkel α angeordnet, der größer als 0° ist und maximal so groß ist, daß die zweite Kamera CAM2 mit der ersten Kamera CAM1 nicht in Berührung kommt.

Beide Kameras CAM1, CAM2 sind mit einer Auswerteeinrichtung PC verbunden, die der Steuerung der Kameras CAM1, CAM2 dient sowie zur Erfassung, zur Zwischenspeicherung, zur Weiterverarbeitung und zur Ausgabe von von den Kameras CAM1, CAM2 erhaltenen Daten bzw. Bildern.

Damit sich im Betrieb die beiden verschiedenen Beleuchtungsarten (direkte und indirekte Beleuchtung) mit ihren Lichtbedingungen einschließlich auftretender bzw. zu unterbindender Reflexionen unter anderem an der halbkugelförmigen Abdeckeinrichtung HK möglichst wenig gegenseitig beeinflussen, wurde das System mit den zueinander komplementären Farben Gn, Rt der Beleuchtungseinrichtungen Lt1, Lt2 und den entsprechend gestalteten Oberflächen der Abdeckeinrichtung HK sowie der Bodenplatte Pl gewählt.

Weiterhin ist es günstig, wenn bei einer der beiden Kameras CAM1, CAM2 oder bei beiden Kameras CAM1, CAM2 im Raum Rm innerhalb der halbkugelförmigen Abdeckeinrichtung HK befindliche Teile der Kameras CAM1 und/oder CAM2 so angeordnet sind, daß sie, von der Halbleiterscheibe WF bzw. der Einrichtung E her betrachtet, durch das Objektiv Obj der jeweiligen Kamera CAM1, CAM2 verdeckt sind.

Darüber hinaus ist es vorteilhaft, wenn wenigstens eine der beiden Beleuchtungseinrichtungen Lt1, Lt2 und/oder die weitere Abdeckeinrichtung K ringförmig ist bzw. angeordnet ist.

Auch die Einrichtung E zur Aufnahme der Halbleiterscheiben WF kann auf verschiedene Arten vorteilhaft ausgestaltet sein: Als Bestandteil der Bodenplatte Pl, angeordnet auf der Bodenplatte Pl oder in diese (Pl) eingelassen.

Ebenso ist es vorteilhaft (entsprechend der zweiten Vorrichtung), wenn der Winkel α, in dem die zweite Kamera CAM2 bezüglich des Mittelpunktes der Einrichtung E angeordnet ist, 40° bis 70° beträgt. Optimal ist eine Anordnung von 60°.

## Patentansprüche

1. Vorrichtung zur Kontrolle von **Halbleiterscheiben mit folgenden Merkmalen:**
- eine Einrichtung (E) zur Aufnahme der zu kontrollierenden Halbleiterscheibe (WF) und
- eine halbkugelförmige Abdeckeinrichtung (HK) mit einer innenliegenden Oberfläche (K2);
- die halbkugelförmige Abdeckeinrichtung (HK) bildet innerhalb ihres halbkugelförmigen Bereiches einen Innenraum (Rm),
- innerhalb dieses Innenraumes (Rm) sind aus Sicht der halbkugelförmigen Abdeckeinrichtung (HK) eine Beleuchtungseinrichtung (Lt2) zur Beleuchtung der Halbleiterscheibe (WF) mit dem Licht (Lt) und die Einrichtung (E) zur Aufnahme der zu kontrollierenden Halbleiterscheibe (WF) an der an den Innenraum (Rm) und an die halbkugelförmige Abdeckeinrichtung (HK) angrenzenden Bodenfläche angeordnet, wobei die Einrichtung (E) zur Aufnahme der zu kontrollierenden Halbleiterscheibe (WF) zentral an der angrenzenden Bodenfläche angeordnet ist,
- zwischen der Beleuchtungseinrichtung (Lt2) und der Einrichtung (E) zur Aufnahme der zu kontrollierenden Halbleiterscheibe (WF) ist eine weitere Abdeckeinrichtung (K) zur Absorption von auftreffendem Licht (Lt) angeordnet,
- die weitere Abdeckeinrichtung (K) ist so ausgebildet, daß die Halbleiterscheibe (WF) mit der Beleuchtungseinrichtung (Lt2) nur durch Reflexion des Lichtes (Lt) an der halbkugelförmigen Abdeckeinrichtung (HK) beleuchtbar ist;
- an der halbkugelförmigen Abdeckeinrichtung (HK) ist eine Kamera (CAM) so angeordnet, daß ihr Objektiv (Obj) in den Innenraum (Rm) innerhalb der halbkugelförmigen Abdeckeinrichtung (HK) blickt,
- die Kamera (CAM) ist mit einer Auswerteeinrichtung (PC) verbunden, die der Steuerung der Kamera (CAM) dient sowie zum Empfang, zur Zwischenspeicherung, zur Verarbeitung und zur Ausgabe von von der Kamera (CAM) übermittelten Daten,
- die Kamera (CAM) ist bezüglich des Mittelpunktes der Einrichtung (E) zur Aufnahme der zu kontrollierenden Halbleiterscheibe (WF) in einem Winkel (α) (zur Bodenfläche) angeordnet, der größer als 0° und kleiner als 90° ist;
- die halbkugelförmige Abdeckeinrichtung (HK) weist im Innenraum (Rm) eine Oberfläche (K2) auf, welche von innen auf die Abdeckeinrichtung (HK) auftreffendes Licht (Lt) in hohem Maße reflektiert.

2. Vorrichtung nach Anspruch 1,
**dadurch gekennzeichnet**, daß die weitere Abdeckeinrichtung (K) eine schwarze Oberfläche aufweist.

3. Vorrichtung nach einem der vorhergehenden Ansprüche,
**dadurch gekennzeichnet**, daß der Winkel (α), in dem die Kamera (CAM) angeordnet ist, 40° bis 70° beträgt, vorzugsweise 60°.

4. Vorrichtung nach einem der vorhergehenden Ansprüche,
**dadurch gekennzeichnet**, daß die das Licht reflektierende Oberfläche (K2) weiß ist.

5. Vorrichtung nach einem der vorhergehenden Ansprüche,
**dadurch gekennzeichnet**, daß das Objektiv (Obj) der Kamera (CAM) ein Rotfilter (F) aufweist.

6. Vorrichtung nach einem der vorhergehenden Ansprüche,
**dadurch gekennzeichnet**, daß der Innenraum (Rm) an der Einrichtung (E) zur Aufnahme der zu kontrollierenden Halbleiterscheibe (WF) mittels einer Bodenplatte (Pl) weitgehend abgeschlossen ist.

7. Vorrichtung nach Anspruch 6,
**dadurch gekennzeichnet**, daß die Einrichtung (E) zur Aufnahme der zu kontrollierenden Halbleiterscheibe (WF) Bestandteil der Bodenplatte (Pl) ist.

8. Vorrichtung nach Anspruch 6,
**dadurch gekennzeichnet**, daß die Einrichtung (E) zur Aufnahme der zu kontrollierenden Halbleiterscheibe (WF) auf der Bodenplatte (Pl) angeordnet ist oder in diese (Pl) eingelassen ist.

9. Vorrichtung nach einem der vorhergehenden Ansprüche,
**dadurch gekennzeichnet**, daß das Licht (Lt) weiß ist.

10. Vorrichtung nach einem der Ansprüche 6 bis 9,
**dadurch gekennzeichnet**, daß die Oberfläche der Bodenplatte (Pl) auf ihrer der halbkugelförmigen Abdeckeinrichtung (HK) zugewandten Oberfläche schwarz ist.

11. Vorrichtung nach einem der vorhergehenden Ansprüche,
**dadurch gekennzeichnet**, daß im innenraum (Rm) befindliche weitere Teile der Kamera (CAM) so angeordnet sind, daß diese, von der Halbleiterscheibe (WF) her betrachtet, durch das Objektiv (Obj) verdeckt sind.

12. Vorrichtung nach einem der vorhergehenden Ansprüche,
**dadurch gekennzeichnet**, daß die Beleuchtungseinrichtung (Lt2) ringförmig ist..

13. Vorrichtung nach einem der vorhergehenden Ansprüche,
**dadurch gekennzeichnet**, daß die weitere Abdeckeinrichtung (K) ringförmig angeordnet ist.

14. Vorrichtung zur Kontrolle von Halbleiterscheiben mit folgenden Merkmalen:
- eine Einrichtung (E) zur Aufnahme der zu kontrollierenden Halbleiterscheibe (WF) und
- eine halbkugelförmige Abdeckeinrichtung (HK) mit einer innenliegenden Oberfläche (K3) von einer ersten Farbe (Rt);
- die halbkugelförmige Abdeckeinrichtung (HK) bildet innerhalb ihres halbkugelförmigen Bereiches einen Innenraum (Rm),
- innerhalb dieses Innenraumes (Rm) sind an der an den Innenraum (Rm) und an die halbkugelförmige Abdeckeinrichtung (HK) angrenzenden Bodenfläche angeordnet:
-- aus Sicht der halbkugelförmigen Abdeckeinrichtung (HK) eine erste Beleuchtungseinrichtung (Lt1) zur Beleuchtung der Halbleiterscheibe (WF) mit nicht an der halbkugelförmigen Abdeckeinrichtung (HK) reflektiertem Licht einer zweiten Farbe (Gn) und
-- die Einrichtung (E) zur Aufnahme der zu kontrollierenden Halbleiterscheibe (WF), die zentral an der angrenzenden Bodenfläche angeordnet ist,
-- oberhalb der ersten Beleuchtungseinrichtung (Lt1) eine zweite Beleuchtungseinrichtung (Lt2) zur Beleuchtung der Halbleiterscheibe (WF) durch Reflexion an der halbkugelförmigen Abdeckeinrichtung (HK) mit Licht der ersten Farbe (Rt), die zur zweiten Farbe (Gn) komplementär ist,
-- oberhalb der ersten Beleuchtungseinrichtung (Lt1) eine weitere, für auftreffendes Licht (Lt) undurchlässige Abdeckeinrichtung (K), die so ausgebildet ist, daß einerseits die Halbleiterscheibe (WF) mittels der ersten Beleuchtungseinrichtung (Lt1) mit nicht an der halbkugelförmigen Abdeckeinrichtung (HK) reflektiertem Licht (Lt) beleuchtbar ist und daß andererseits die Halbleiterscheibe (WF) durch die zweite Beleuchtungseinrichtung (Lt2) nur durch Reflexion des Lichtes (Lt) an der halbkugelförmigen Abdeckeinrichtung (HK) beleuchtbar ist;
- senkrecht oberhalb des Mittelpunktes der Einrichtung (E) zur Aufnahme der zu kontrollierenden Halbleiterscheibe (WF) ist an der halbkugelförmigen Abdeckeinrichtung (HK) eine erste Kamera (CAM1) so angeordnet, daß ihr Objektiv (Obj) in den Innenraum (Rm) blickt;
- die erste Kamera (CAM1) weist ein Filter (F1) auf, welches nur Licht der zweiten Farbe (Gn) passieren läßt;
- weiterhin ist an der halbkugelförmigen Abdeckeinrichtung (HK) eine zweite Kamera (CAM2) so angeordnet, daß ihr Objektiv (Obj) in den Innenraum (Rm) blickt;
- die zweite Kamera (CAM2) weist ein Filter (F2) auf, welches nur Licht der ersten Farbe (Rt) passieren läßt;
- die zweite Kamera (CAM2) ist bezüglich des Mittelpunktes der Einrichtung (E) zur Aufnahme der zu kontrollierenden Halbleiterscheibe (WF) in einem Winkel (α) zur Bodenfläche angeordnet, der größer ist als 0°;
- beide Kameras (CAM1, CAM2) sind mit einer Auswerteeinrichtung (PC) verbunden, die der Steuerung der Kameras (CAM1, CAM2) dient sowie zum Empfang, zur Zwischenspeicherung, zur Weiterverarbeitung und zur Ausgabe von von den Kameras (CAM1, CAM2) erhaltenen übermittelten Daten.

15. Vorrichtung nach Anspruch 14,
**dadurch gekennzeichnet**, daß die weitere Abdeckeinrichtung (K) eine schwarze Oberfläche aufweist.

16. Vorrichtung nach Anspruch 14 oder 15,
**dadurch gekennzeichnet**, daß bei wenigstens einer der beiden Kameras (CAM1, CAM2) im Raum (Rm) innerhalb der halbkugelförmigen Abdeckeinrichtung (HK) befindliche weitere Teile der Kamera (CAM1; CAM2) so angeordnet sind, daß diese, von der Halbleiterscheibe (WF) her betrachtet, durch das Objektiv der betreffenden Kamera (CAM1; CAM2) verdeckt sind.

17. Vorrichtung nach einem der Ansprüche 14 bis 16,
**dadurch gekennzeichnet**, daß wenigstens eine der beiden Beleuchtungseinrichtungen (Lt1, Lt2) ringförmig ist.

18. Vorrichtung nach einem der Ansprüche 14 bis 17,
**dadurch gekennzeichnet**, daß die weitere Abdeckeinrichtung (K) ringförmig angeordnet ist.

19. Vorrichtung nach einem der Ansprüche 14 bis 18,
dadurch gekennzeichnet, daß der Innenraum (Rm) an der Einrichtung (E) zur Aufnahme der zu kontrollierenden Halbleiterscheibe (WF) mittels einer Bodenplatte (Pl) weitgehend abgeschlossen.

20. Vorrichtung nach Anspruch 19,
**dadurch gekennzeichnet**, daß die Einrichtung (E) zur Aufnahme der zu kontrollierenden Halbleiterscheibe (WF) Bestandteil der Bodenplatte (Pl) ist.

21. Vorrichtung Anspruch 19,
**dadurch gekennzeichnet**, daß die Einrichtung (E) zur Aufnahme der zu kontrollierenden Halbleiterscheibe (WF) auf der Bodenplatte (Pl) angeordnet ist oder in diese (Pl) eingelassen ist.

22. Vorrichtung nach einem der Ansprüche 14 bis 21,
**dadurch gekennzeichnet**, daß der Winkel (α), in dem die zweite Kamera (CAM2) angeordnet ist, 40° bis 70° beträgt, vorzugsweise 60°.

23. Vorrichtung nach einem der Ansprüche 14 bis 22,
**dadurch gekennzeichnet**, daß die zweite Farbe (Gn) grün ist.

24. Vorrichtung nach einem der Ansprüche 14 bis 23,
**dadurch gekennzeichnet**, daß die erste Farbe (Rt) rot ist.

## Claims

1. Apparatus for inspecting semiconductor wafers having the following features:
- a device (E) for accommodating the semiconductor wafers (WF) to be inspected and
- a hemispherical covering device (HK) having an internal surface (K2);
- the hemispherical covering device (HK) forms an internal space (Rm) within its hemispherical region,
- within this internal space (Rm), from the standpoint of the hemispherical covering device (HK), an illumination device (Lt2) for illuminating the semiconductor wafer (WF) with the light (Lt), and the device (E) for accommodating the semiconductor wafer (WF) to be inspected are arranged on the base area adjoining the internal space (Rm) and the hemispherical covering device (HK), the device (E) for accommodating the semiconductor wafer (WF) to be inspected being arranged centrally on the adjoining base area,
- a further covering device (K), for absorbing impinging light (Lt) is arranged between the illumination device (Lt2) and the device (E) for accommodating the semiconductor wafer (WF) to be inspected,
- the further covering device (K) is designed in such a way that the semiconductor wafer (WF) can be illuminated by the illumination device (Lt2) only by reflection of the light (Lt) from the hemispherical covering device (HK);
- a camera (CAM) is arranged on the hemispherical covering device (HK) in such a way that its objective (Obj) looks into the internal space (Rm) within the hemispherical covering device (HK),
- the camera (CAM) is connected to an evaluation device (PC) which serves for controlling the camera (CAM) and for receiving, for buffer-storing, for processing and for outputting data communicated by the camera (CAM),
- the camera (CAM) is arranged, with regard to the midpoint of the device (E) for accommodating the semiconductor wafer (WF) to be inspected, at an angle (α) with respect to the base area which is greater than 0° and less than 90°;
- in the internal space (Rm), the hemispherical covering device (HK) has a surface (K2) which greatly reflects light (Lt) impinging on the covering device (HK) from the inside.

2. Apparatus according to Claim 1,
characterized in that the further covering device (K) has a black surface.

3. Apparatus according to one of the preceding claims,
characterized in that the angle (α) at which the camera (CAM) is arranged is 40° to 70°, preferably 60°.

4. Apparatus according to one of the preceding claims,
characterized in that the light-reflecting surface (K2) is white.

5. Apparatus according to one of the preceding claims,
characterized in that the objective (Obj) of the camera (CAM) has a red filter (F).

6. Apparatus according to one of the preceding claims,
characterized in that the internal space (Rm) is largely closed off by means of a baseplate (P1) at the device (E) for accommodating the semiconductor wafer (WF) to be inspected.

7. Apparatus according to Claim 6,
characterized in that the device (E) for accommodating the semiconductor wafer (WF) to be inspected is part of the baseplate (P1).

8. Apparatus according to Claim 6,
characterized in that the device (E) for accommodating the semiconductor wafer (WF) to be inspected is arranged on the baseplate (P1) or is let into the latter (P1).

9. Apparatus according to one of the preceding claims,
characterized in that the light (Lt) is white.

10. Apparatus according to one of Claims 6 to 9,
characterized in that the surface of the baseplate (P1) is black on its surface facing the hemispherical covering device (HK).

11. Apparatus according to one of the preceding claims,
characterized in that further parts of the camera (CAM) which are situated in the internal space (Rm) are arranged in such a way that they are concealed by the objective (Obj), as viewed from the semiconductor wafer (WF).

12. Apparatus according to one of the preceding claims,
characterized in that the illumination device (Lt2) is annular.

13. Apparatus according to one of the preceding claims,
characterized in that the further covering device (K) is arranged annularly.

14. Apparatus for inspecting semiconductor wafers having the following features:
- a device (E) for accommodating the semiconductor wafer (WF) to be inspected and
- a hemispherical covering device (HK) having an internal surface (K3) of a first colour (Rt);
- the hemispherical covering device (HK) forms an internal space (Rm) within its hemispherical region,
- within this internal space (Rm), the following are arranged on the base area adjoining the internal space (Rm) and the hemispherical covering device (HK) :
- - from the standpoint of the hemispherical covering device (HK), a first illumination device (Lt1) for illuminating the semiconductor wafer (WF) with light of a second colour (Gn), which light is not reflected from the hemispherical covering device (HK), and
- - the device (E) for accommodating the semiconductor wafer (WF) to be inspected, which is arranged centrally on the adjoining base area,
- - above the first illumination device (Lt1), a second illumination device (Lt2) for illuminating the semiconductor wafer (WF) by reflection from the hemispherical covering device (HK) with light of the first colour (Rt), which is complementary to the second colour (Gn),
- - above the first illumination device (Lt1), a further covering device (K), which is opaque to impinging light (Lt) and is designed in such a way that, on the one hand, the semiconductor wafer (WF) can be illuminated by means of the first illumination device (Lt1) with light (Lt) that is not reflected from the hemispherical covering device (HK), and that, on the other hand, the semiconductor wafer (WF) can be illuminated by the second illumination device (Lt2) only by reflection of the light (Lt) from the hemispherical covering device (HK);
- perpendicularly above the midpoint of the device (E) for accommodating the semiconductor wafer (WF) to be inspected, a first camera (CAM1) is arranged on the hemispherical covering device (HK) in such a way that its objective (Obj) looks into the internal space (Rm);
- the first camera (CAM1) has a filter (F1) which allows only light of the second colour (Gn) to pass through;
- furthermore, a second camera (CAM2) is arranged on the hemispherical covering device (HK) in such a way that its objective (Obj) looks into the internal space (Rm);
- the second camera (CAM2) has a filter (F2) which allows only light of the first colour (Rt) to pass through;
- the second camera (CAM2) is arranged, with regard to the midpoint of the device (E) for accommodating the semiconductor wafer (WF) to be inspected, at an angle (α) with respect to the base area which is greater than 0°;
- both cameras (CAM1, CAM2) are connected to an evaluation device (PC) which serves for controlling the cameras (CAM1, CAM2) and for receiving, for buffer-storing, for further processing and for outputting communicated data received from the cameras (CAM1, CAM2).

15. Apparatus according to Claim 14,
characterized in that the further covering device (K) has a black surface.

16. Apparatus according to Claim 14 or 15,
characterized in that, in the case of at least one of the two cameras (CAM1, CAM2), further parts of the camera (CAM1: CAM2) which are situated in the space (Rm) within the hemispherical covering device (HK) are arranged in such a way that they are concealed by the objective of the relevant camera (CAM1; CAM2), as viewed from the semiconductor wafer (WF).

17. Apparatus according to one of Claims 14 to 16,
characterized in that at least one of the two illumination devices (Lt1, Lt2) is annular.

18. Apparatus according to one of Claims 14 to 17,
characterized in that the further covering device (K) is arranged annularly.

19. Apparatus according to one of Claims 14 to 18,
characterized in that the internal space (Rm) is largely closed off by means of a baseplate (Pl) at the device (E) for accommodating the semiconductor wafer (WF) to be inspected.

20. Apparatus according to Claim 19,
characterized in that the device (E) for accommodating the semiconductor wafer (WF) to be inspected is part of. the baseplate (Pl).

21. Apparatus according to Claim 19,
characterized in that the device (E) for accommodating the semiconductor wafer (WF) to be inspected is arranged on the baseplate (Pl) or is let into the latter (Pl).

22. Apparatus according to one of Claims 14 to 21,
characterized in that the angle (α) at which the second camera (CAM2) is arranged is 40° to 70°, preferably 60°.

23. Apparatus according to one of Claims 14 to 22,
characterized in that the second colour (Gn) is green.

24. Apparatus according to one of Claims 14 to 23,
characterized in that the first colour (Rt) is red.

## Revendications

1. Système pour inspecter ou contrôler des plaquettes de semi-conducteur avec les caractéristiques suivantes:
- un dispositif (E), destiné à recevoir la plaquette de semi-conducteur (WF) à vérifier, et
- un dispositif de recouvrement (HK) de forme hémisphérique avec une surface intérieure (K2);
- le dispositif de recouvrement (HK) de forme hémisphérique forme un espace (Rm) à l'intérieur de sa zone de forme hémisphérique,
- à l'intérieur de cet espace intérieur (Rm) sont disposés, au niveau de la surface de base qui limite l'espace intérieur Rm et le dispositif de recouvrement (HK) de forme hémisphérique, vus du dispositif de recouvrement (HK) de forme hémisphérique, un dispositif d'éclairage (Lt2) pour l'éclairage de la plaquette de semi-conducteur (WF) avec la lumière (Lt) et le dispositif (E), destiné à recevoir la plaquette de semi-conducteur (WF) à vérifier, le dispositif (E), destiné à recevoir la plaquette de semi-conducteur (WF) à vérifier, étant disposé au centre de la surface de base limitrophe,
- entre le dispositif d'éclairage (Lt2) et le dispositif (E), destiné à recevoir la plaquette de semi-conducteur (WF) à vérifier, est disposé un autre dispositif de recouvrement (K) pour absorber la lumière incidente (Lt),
- l'autre dispositif de recouvrement (K) est conçu de telle sorte que la plaquette de semi-conducteur (WF) ne peut être éclairé par le dispositif d'éclairage (Lt2) que par réflexion de la lumière (Lt) sur le dispositif de recouvrement (HK) de forme hémisphérique;
- sur le dispositif de recouvrement (HK) de forme hémisphérique est disposé un àppareil photographique (CAM) de telle sorte que son objectif (Obj) est tourné vers l'espace intérieur (Rm) à l'intérieur du dispositif de recouvrement (HK) de forme hémisphérique,
- l'appareil photographique (CAM) est relié à un dispositif d'évaluation (PC), qui sert à la commande de l'appareil photographique (CAM), ainsi qu'à la réception, la mémorisation temporaire, le traitement et la sortie de données transmises par l'appareil photographique (CAM),
- l'appareil photographique (CAM) est, par rapport au centre du dispositif (E), destiné à recevoir la plaquette de semi-conducteur (WF) à vérifier, disposé sous un angle (α) par rapport à la surface de base, qui est supérieur à 0° et inférieur à 90°;
- le dispositif de recouvrement (HK) de forme hémisphérique comporte, dans son espace intérieur (Rm), une surface (K2), qui réfléchit fortement la lumière (Lt) qui rencontre de l'intérieur le dispositif de recouvrement (HK).

2. Système selon la revendication 1
**caractérisé par le fait** que l'autre dispositif de recouvrement (K) a une surface noire.

3. Système selon l'une des revendications précédentes
**caractérisé par le fait** que l'angle (α), sous lequel l'appareil photographique (CAM) est disposé, a une valeur de 40° à 70°, de préférence de 60°.

4. Système selon l'une des revendications précédentes
**caractérisé par le fait** que la surface (K2), qui réfléchit la lumière, est blanche.

5. Système selon l'une des revendications précédentes
**caractérisé par le fait** que l'objectif (Obj) de l'appareil photographique (CAM) comporte un filtre rouge (F).

6. Système selon l'une des revendications précédentes
**caractérisé par le fait** que l'espace intérieur (Rm) au niveau du dispositif (E), destiné à recevoir la plaquette de semi-conducteur (WF) à contrôler, est presque complètement fermé par une plaque de base (PI).

7. Système selon, la revendication 6
**caractérisé par le fait** que le dispositif (E), destiné à recevoir la plaquette de semi-conducteur (WF) à contrôler, est partie intégrante de la plaque de base (PI).

8. Système selon la revendication 6
**caractérisé par le fait** que le dispositif (E), destiné à recevoir la plaquette de semi-conducteur (WF) à contrôler, est disposé sur la plaque de base (PI) ou est encastré dans celle-ci (PI).

9. Système selon l'une des revendications précédentes
**caractérisé par le fait** que la lumière (Lt) est blanche.

10. Système selon l'une des revendications 6 à 9
**caractérisé par le fait** que la surface de la plaque de base (PI), tournée vers le dispositif de recouvrement (HK) de forme hémisphérique, est noire.

11. Système selon l'une des revendications précédentes
**caractérisé par le fait** que d'autres pièces de l'appareil photographique (CAM), qui se trouvent dans l'espace intérieur (Rm), sont disposées de telle sorte que celles-ci, vues de la plaquette de semi-conducteur (WF), sont dissimulées par l'objectif (Obj).

12. Système selon l'une des revendications précédentes
**caractérisé par le fait** que le dispositif d'éclairage (Lt2) est de forme circulaire.

13. Système selon l'une des revendications précédentes
**caractérisé par le fait** que l'autre dispositif de recouvrement (K) est disposé d'une façon circulaire.

14. Système pour contrôler des plaquettes de semi-conducteur avec les caractéristiques suivantes:
- un dispositif (E), destiné à recevoir la plaquette de semi-conducteur (WF) à vérifier, et
- un dispositif de recouvrement (HK) de forme hémisphérique avec une surface intérieure (K3) d'une première couleur (Rt);
- le dispositif de recouvrement (HK) de forme hémisphérique forme un espace (Rm) à l'intérieur de sa zone de forme hémisphérique,
- à l'intérieur de cet espace intérieur (Rm) sont disposés, au niveau de la surface de base qui limite l'espace intérieur Rm et le dispositif de recouvrement (HK) de forme hémisphérique,:
- - vu du dispositif de recouvrement (HK) de forme hémisphérique, un premier dispositif d'éclairage (Lt1) pour l'éclairage de la plaquette de semi-conducteur (WF) avec de la lumière d'une deuxième couleur (Gn) non réfléchie sur le dispositif de recouvrement (HK) de forme hémisphérique et
- - le dispositif (E), destiné à recevoir la plaquette de semi-conducteur (WF) à vérifier, qui est disposé au centre de la surface de base limitrophe,
- - au dessus du premier dispositif d'éclairage (Lt1), un deuxième dispositif d'éclairage (Lt2) pour l'éclairage de la plaquette de semi-conducteur (WF) par réflexion, sur le dispositif de recouvrement (HK) de forme hémisphérique, de lumière de la première couleur (Rt), qui est complémentaire de la deuxième couleur (Gn),
- - au dessus du premier dispositif d'éclairage (Lt1), un autre dispositif de recouvrement (K), qui est opaque pour la lumière incidente (Lt) et qui est conçu de telle sorte que, d'une part, la plaquette de semi-conducteur (WF) peut être éclairée, grâce au premier dispositif d'éclairage (Lt1), avec de la lumière non réfléchie sur le dispositif de recouvrement (HK) de forme hémisphérique et que, d'autre part, la plaquette de semi-conducteur (WF) peut être éclairée, grâce au deuxième dispositif d'éclairage (Lt2), seulement par réflexion de la lumière (Lt) sur le dispositif de recouvrement (HK) de forme hémisphérique;
- à la verticale au dessus du centre du dispositif (E), destiné à recevoir la plaquette de semi-conducteur (WF) à vérifier, est disposé, sur le dispositif de recouvrement (HK) de forme hémisphérique, un premier appareil photographique (CAM1) de telle sorte que son objectif (Obj) est tourné vers l'espace intérieur (Rm);
- le premier appareil photographique (CAM1) comporte un filtre (F1), qui ne laisse passer que de la lumière de la deuxième couleur (Gn);
- en outre, un deuxième appareil photographique (CAM2) est disposé sur le dispositif de recouvrement (HK) de forme hémisphérique de telle sorte que son objectif (Obj) est tourné vers l'espace intérieur (Rm);
- le deuxième appareil photographique (CAM2) comporte un filtre (F2), qui ne laisse passer que de la lumière de la première couleur (Rt);
- le deuxième appareil photographique (CAM2) est disposé, par rapport au centre du dispositif (E), destiné à recevoir la plaquette de semi-conducteur (WF) à vérifier, sous un angle (α) par rapport à la surface de base, qui est supérieur à 0°;
- les deux appareils photographiques (CAM1, CAM2) sont reliés à un dispositif d'évaluation (PC), qui sert à la commande des appareils photographiques (CAM1, CAM2), ainsi qu'à la réception, la mémorisation temporaire, le post-traitement et la sortie des données qui lui sont transmises et qui sont obtenues par les appareils photographiques (CAM1, CAM2).

15. Système selon la revendication 14
**caractérisé par le fait** que la surface de l'autre dispositif de recouvrement (K) est noire.

16. Système selon la revendication 14 ou 15
**caractérisé par le fait** que d'autres pièces des appareils photographiques (CAM1, CAM2) qui se trouvent, sur au moins l'un des deux appareils photographiques (CAM1, CAM2) dans l'espace (Rm) à l'intérieur du dispositif de recouvrement (HK) de forme hémisphérique, sont disposées de telle sorte que celles-ci sont, vues de la plaquette de semi-conducteur (WF), cachées par l'objectif de l'appareil photographique (CAM1, CAM2) concerné.

17. Système selon l'une des revendications 14 à 16
**caractérisé par le fait** qu'au moins l'un des deux dispositifs d'éclairage (Lt1, Lt2) est circulaire.

18. Système selon l'une des revendications 14 à 17
**caractérisé par le fait** que l'autre dispositif de recouvrement (K) est disposé d'une façon circulaire.

19. Système selon l'une des revendications 14 à 18
**caractérisé par le fait** que l'espace intérieur (Rm) est presque entièrement fermé, au niveau du dispositif (E), destiné à recevoir la plaquette de semi-conducteur (WF) à vérifier, au moyen d'une plaque de base (Pl).

20. Système selon la revendication 19
**caractérisé par le fait** que le dispositif (E), destiné à recevoir la plaquette de semi-conducteur (WF) à contrôler, est partie intégrante de la plaque de base (PI).

21. Système selon la revendication 19
**caractérisé par le fait** que le dispositif (E), destiné à recevoir la plaquette de semi-conducteur (WF) à contrôler, est disposé sur la plaque de base (Pl) ou est encastré dans celle-ci (Pl).

22. Système selon l'une des revendications 14 à 21
**caractérisé par le fait** que l'angle (α), sous lequel le deuxième appareil photographique (CAM2) est disposé, a une valeur de 40° à 70°, de préférence 60°.

23. Système selon l'une des revendications 14 à 22
**caractérisé par le fait** que la deuxième couleur (Gn) est verte.

24. Système selon l'une des revendications 14 à 23
**caractérisé par le fait** que la première couleur (Rt) est rouge.
